# EUROPÄISCHE PATENTANMELDUNG

(11) **EP 3 441 780 A1**
(43) Veröffentlichungstag der Anmeldung: **13.02.2019**
(21) Anmeldenummer: 17185434.2
(22) Anmeldetag: 09.08.2017
(51) Int. Cl.: G01R 33/36

(54) **MANTELWELLENSPERRENFREIE ANSCHLUSSLEITUNG UND MAGNETRESONANZTOMOGRAPH MIT ANSCHLUSSLEITUNG**

(71) Anmelder: Siemens Healthcare GmbH, 91052 Erlangen (DE)
(72) Erfinder: Popescu, Stefan, 91056 Erlangen (DE)

(57) **Zusammenfassung**

Die Erfindung betrifft eine Anschlussleitung für eine Empfangsantenne eines Magnetresonanztomographen und ein System aus einem Magnetresonanztomographen und einer Empfangsantenne. Die Anschlussleitung weist einen resonanten kontaktlosen Leistungskoppler auf. Die Empfangsantenne ist mittels der Anschlussleitung magnetisch resonant mit dem Magnetresonanztomographen gekoppelt. Der Magnetresonanztomograph weist einen Wechselstromgenerator auf, der mit der Anschlussleitung verbindbar ist und ausgelegt ist, das aktive Verstärkerelement der Empfangsantenne mit Energie zu versorgen.

## Beschreibung

Die Erfindung betrifft eine Anschlussleitung für eine Empfangsantenne eines Magnetresonanztomographen. Die Empfangsantenne weist aktive Verstärkerelemente auf.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden. Die Empfangsantennen können auch in einer Patientenliege verbaut sein.

Die Empfangsantennen sind üblicherweise über eine Anschlussleitung mit einer Empfangseinrichtung des Magnetresonanztomographen verbunden, der empfangene Magnetresonanzsignale auswertet. Die Empfangsantennen weisen auch rauscharme Vorverstärker (low noise amplifier, LNA) auf, die die schwachen Magnetresonanzsignale vor der Übertragung über die Anschlussleitung verstärken. Der für den Betrieb der Vorverstärker erforderliche Strom wird ebenfalls über die gleichen oder separate Adern der Anschlussleitung übertragen. Die Anschlussleitung kann auch Teil einer Patientenliege sein, z.B. in der Patientenliege verbaute Spine-Spulen versorgen oder als Verteiler für an der Patientenliege angeordnete Steckkontakte für externe Lokalspulen dienen.

Die Anregung der Kernspins erfolgt mittels Hochfrequenzpulsen mit Leistungen bis zu einigen Kilowatt, die in einen Untersuchungsbereich des Magnetresonanztomographen abgestrahlt werden. Bei den üblichen Magnetfeldstärken zwischen 0,5 T und 3 T, teilweise auch bis 7 T, haben die Anregungssignale typisch Wellenlängen zwischen 2 m und 15 m, sodass die Kabellängen der Anschlussleitung zum Teil bereits länger als ein Viertel der Wellenlänge sind und selbst als Antenne wirken. Dann können sich auf den Leitern und/oder Abschirmungen resonante Spannungs- und Stromspitzen ausbilden, die den Patienten und auch die Gerätschaften gefährden.

Zur Unterdrückung derartiger induzierter Ströme und Spannungen, auch als Mantelwellen bezeichnet, sind unterschiedliche Mantelwellenfilter bekannt, die die Ausbildung der Mantelwellen unterdrücken sollen. Aus der Druckschrift DE 10 2016 201 441 ist beispielsweise eine Mantelwellensperre bekannt, die auf einem Trägermaterial angeordnet ist. Die Druckschrift DE 10 2013 201 685 beschreibt eine dielektrische Mantelwellensperre.

Aus der Druckschrift DE 10 2013 210 381 A1 ist eine Anschlussleitung aus einem Metamaterial bekannt.

Die bekannten Mantelwellensperren weisen jedoch den Nachteil auf, dass sie für eine bestimmte Frequenz des Anregungssignals optimiert sind. Darüber hinaus sind die Mantelwellensperren schwer und unflexibel.

Es könnte folglich eine Aufgabe der vorliegenden Erfindung sein, eine Anschlussleitung für eine Empfangsantenne eines Magnetresonanztomographen bereitzustellen, die die Handhabung des Magnetresonanztomographen erleichtert.

Die Aufgabe wird durch eine erfindungsgemäße Anschlussleitung nach Anspruch 1 sowie eine Empfangsantenne nach Anspruch 10 und ein System nach Anspruch 13 gelöst.

Die erfindungsgemäße Anschlussleitung für eine Empfangsantenne eines Magnetresonanztomographen mit einem aktiven Verstärkerelement weist einen resonanten, kontaktlosen Leistungskoppler auf. Als resonanter Leistungskoppler im Sinne der Erfindung wird eine Vorrichtung angesehen, die ausgelegt ist, einen Wechselstrom über eine galvanische Trennung hinweg bei einer Resonanzfrequenz der Vorrichtung zu koppeln. Als resonant bei der Resonanzfrequenz wird es dabei angesehen, wenn die Leistungsübertragung bei einer Abweichung um 1%, 2%, 5% oder 10% der Frequenz des Wechselstroms von der Resonanzfrequenz des Leistungskopplers um beispielsweise 6 dB, 12 dB, 18 dB oder mehr abnimmt. Ausführungsformen des resonanten kontaktlosen Leistungskopplers sind nachfolgend in den Unteransprüchen angegeben.

Vorzugsweise weist die erfindungsgemäße Anschlussleitung ein gemeinsames Leiterpaar mit einem gemeinsamen resonanten Leistungskoppler für das MRT-Signal und eine Energieversorgung des aktiven Verstärkerelements auf. Es ist aber auch denkbar, dass die erfindungsgemäße Anschlussleitung mehrere Leiterpaare, beispielsweise verdrillte Adernpaare und/oder Koaxialleitungen jeweils mit einem resonanten kontaktlosen Leistungskoppler aufweist.

Auf vorteilhafte Weise erlaubt der resonante kontaktlose Leistungskoppler in der erfindungsgemäßen Anschlussleitung die Ausbreitung von Signalen nur im Bereich einer Resonanzfrequenz und blockiert die Ausbildung von Mantelwellen auf anderen Frequenzen, sodass die Anschlussleitung ohne Gefahr für eine Vielzahl von Larmorfrequenzen einsetzbar ist.

Die erfindungsgemäße Empfangsantenne weist ein aktives Verstärkerelement und eine Energieversorgung auf. Die Energieversorgung ist ausgelegt, aus einem über die Anschlussleitung übertragenen Hochfrequenzsignal mit der Resonanzfrequenz des resonanten kontaktlosen Leistungskopplers das aktive Verstärkerelement mit Energie zu versorgen. Bei der Empfangsantenne handelt es sich vorzugsweise um eine Lokalspule, denkbar ist aber auch eine fest mit dem Magnetresonanztomographen bzw. der Patientenliege verbundene Spule wie beispielsweise ein Körperspule oder Spine-Spule. Die erfindungsgemäße Empfangsantenne teilt die Vorteile der Anschlussleitung.

Das erfindungsgemäße System weist die erfindungsgemäße Anschlussleitung, einen Magnetresonanztomographen und die Empfangsantenne auf. Die Empfangsantenne ist mittels der Anschlussleitung magnetisch resonant mit dem Magnetresonanztomographen gekoppelt. Magnetisch-resonant bezeichnet dabei eine Kopplung, bei der eine im magnetischen Feld gespeicherte Energie wieder zurückgespeist wird und nicht in Form einer elektromagnetischen Welle abgestrahlt wir. Das schließt nicht aus, dass zumindest abschnittsweise in der erfindungsgemäßen Anschlussleitung eine Kopplung bzw. Signal- oder Energieübertragung durch elektrische Leitung in einem Leiter erfolgt. Weiterhin ist es auch denkbar, dass zu der Verbindung zwischen Empfangsantenne und Magnetresonanztomograph streckenweise auch durch andere, nicht erfindungsgemäße Leitungen beitragen, beispielsweise in abgeschirmten Bereichen ohne Einstrahlung durch Anregungspulse.

Der Magnetresonanztomograph des erfindungsgemäßen Systems weist einen Wechselstromgenerator auf. Der Wechselstromgenerator ist mit der Anschlussleitung verbindbar und ausgelegt, das aktive Verstärkerelement der Empfangsantenne mit Energie zu versorgen. Der Wechselstromgenerator hat also eine ausreichende Leistung um das aktive Verstärkerelement mit der gelieferten Energie zu betreiben. Dabei ist der Wechselstromgenerator ausgelegt, einen Wechselstrom mit einer Frequenz zu erzeugen, die im Wesentlichen gleich einer Resonanzfrequenz des resonanten kontaktlosen Leistungskopplers ist. Als im Wesentlichen gleich der Resonanzfrequenz ist dabei so zu verstehen, dass der von dem Wechselstromgenerator erzeugte Wechselstrom den resonanten kontaktlosen Leistungskoppler mit einer Dämpfung von weniger als 1,5 dB, 3 dB, 6 dB oder 12 dB im Vergleich zu einem Wechselstrom mit genau der Resonanzfrequenz passiert.

Auf vorteilhafte Weise ermöglicht das erfindungsgemäße System einen Betrieb der Empfangsspule bei beliebigen Larmorfrequenzen, sofern die Larmorfrequenz ausreichend von der Resonanzfrequenz des resonanten kontaktlosen Leistungskopplers abweicht.

Weitere vorteilhafte Ausführungsformen sind in den Unteransprüchen angegeben.

In einer denkbaren Ausführungsform der erfindungsgemäßen Anschlussleitung ist eine Resonanzfrequenz des resonanten kontaktlosen Leistungskopplers ungleich einer Larmorfrequenz des Magnetresonanztomographen. Als Resonanzfrequenz des Leistungskopplers ist im Sinne der Erfindung eine Frequenz bezeichnet, bei der die Leistungsübertragung für einen Wechselstrom über den Leistungskoppler ein Maximum beziehungsweise die Dämpfung ein Minimum in Abhängigkeit von der Frequenz annimmt. Vorzugsweise nimmt die Dämpfung dabei für Frequenzen oberhalb und unterhalb der Resonanzfrequenz zu, insbesondere handelt es sich um ein globales Maximum. Die Larmorfrequenz ist im Sinne der Erfindung ungleich, wenn die Dämpfung eines Wechselstromes mit Larmorfrequenz gegenüber einem Wechselstrom mit Resonanzfrequenz bei einem Durchgang durch den resonanten kontaktlosen Leistungskoppler größer als 12 dB, 18 dB, oder 24 dB ist.

Eine Leistungsübertragung bei einer Resonanzfrequenz ungleich der Larmorfrequenz sichert auf vorteilhafte Weise eine effiziente Energieübertragung über den resonanten kontaktlosen Leistungskoppler als auch eine sichere Unterdrückung von Mantelwellen bei der Larmorfrequenz.

In einer möglichen Ausführung der Anschlussleitung weist die Anschlussleitung zwei oder mehrere resonanten Leistungskoppler auf. Vorzugsweise ist ein zweiter resonanter kontaktloser Leistungskoppler in einem Abstand entlang der Anschlussleitung zu dem ersten resonanten kontaktlosen Leistungskoppler angeordnet, der kleiner ist als ein Viertel der Wellenlänge einer Radiowelle mit der höchsten durch den Magnetresonanztomographen auszuwertenden Larmorfrequenz. Der Abstand ist beispielsweise kleiner als 2 m, 1 m, 0,5 m oder 0,25 m. Dabei sind die beiden Leistungskoppler jeweils dem gleichen Leiterpaar bzw. Adernpaar der Anschlussleitung zugeordnet, sodass sich kein durchgehendes ohmsch oder für eine Wechselspannung mit einer Frequenz ungleich der Resonanzfrequenz leitendes Leitungssegment größer als der genannte Abstand ausbildet, das als Antenne für einen Anregungspuls eine hohe Spannung aufbaut. Für mehrere parallele Leiterpaare ist jeweils ein eigener resonanter kontaktloser Leitungskoppler vorgesehen.

Auf vorteilhafte Weise segmentieren zwei oder mehr resonante kontaktlose Leistungskoppler in einem Abstand kleiner als eine Viertel der Wellenlänge den bzw. die Leiter der Anschlussleitung, sodass die einzelnen Segmente unter Einwirkung der Anregungspulse lediglich ungefährliche Spannungen bzw. Ströme aufbauen.

In einer denkbaren Ausführungsform der erfindungsgemäßen Anschlussleitung weist der resonante kontaktlose Leistungskoppler einen ersten Anschluss und einen zweiten Anschluss mit jeweils zwei Polen und weiterhin einen Isolator auf. Dabei sind der erste Anschluss und der zweite Anschluss durch den Isolator galvanisch voneinander isoliert. Mit anderen Worten, auch ein erstes Leiterpaare und ein zweites Leiterpaar, wobei das erste Leiterpaar mit dem ersten Anschluss und das zweite Leiterpaar mit dem zweiten Anschluss elektrisch verbunden ist, sind galvanisch, d.h. für einen Gleichstrom, voneinander isoliert.

Auf vorteilhafte Weise schließt die galvanische Trennung das Entstehen von Mantelwellen für niedrige Frequenzen aus.

In einer möglichen Ausführungsform der erfindungsgemäßen Anschlussleitung sind die Pole des ersten Anschlusses durch eine erste Leiterschleife miteinander verbunden und die Pole des zweiten Anschlusses durch eine zweite Leiterschleife miteinander verbunden. Die erste und die zweite Leiterschleife können beispielsweise eine einzelne Windung aufweisen oder auch mehrere. Vorzugsweise umschließt dabei die Leiterschleife eine möglichst große Fläche, beispielsweise in Form eines Kreises, einer Ellipse oder eines Polygons. Als möglichst groß ist dabei zu verstehen, dass die Fläche nicht kleiner als 70%, 50% 25% oder 10% der Fläche eines Kreises mit gleichem Umfang ist. Die erste Leiterschleife ist durch den Isolator von der zweiten Leiterschleife getrennt. Beispielsweise können die erste Leiterschleife und die zweite Leiterseite auf gegenüberliegenden Oberflächen einer Leiterplatte als Leiterbahn angelegt sein, wobei die Leiterplatte auch als flexible Leiterplatte ausgeführt sein kann. Dabei ist eine Projektion einer von der ersten Leiterschleife umschlossen ersten Fläche auf eine von der zweiten Leiterschleife umschlossenen zweite Fläche von der zweite Fläche im Wesentlichen umfasst. Als im Wesentlichen ist so zu verstehen, dass die Projektion mehr als 90%, 70%, 50% oder 20% der von der zweiten Leiterschleife umschlossenen Fläche einnimmt. Mit anderen Worten, die erste Fläche und die zweite Fläche stehen sich so gegenüber, dass ein von einem Wechselstrom in der ersten Leiterschleife induziertes Magnetfeld die von der zweiten Leiterschleife umgebene zweite Fläche durchdringt, sodass bei der Resonanzfrequenz ein Wechselstrom und eine Wechselspannung in der zweiten Leiterschleife induziert werden, die mindestens 90%, 70%, 50% oder 20% der Leistung des an der ersten Leiterschleife anliegenden Wechselspannung und des fließenden Wechselstromes annehmen.

Auf vorteilhafte Weise bieten zwei durch magnetische Wechselfelder gekoppelte Leiterschleifen eine einfache Möglichkeit, Signale und Energie bei gleichzeitiger galvanischer Entkopplung resonant zu übertragen.

In einer denkbaren Ausführungsform der erfindungsgemäßen Anschlussleitung ist die erste Leiterschleife mit einem resonanzbildenden Element elektrisch und/oder magnetisch gekoppelt. Als elektrisch und/oder magnetisch gekoppelt ist dabei zu so verstehen, dass das resonanzbildende Element eine Veränderung der Amplitude des Wechselstromes und/oder Wechselspannung bei der Resonanzfrequenz um 6 dB, 12 dB, 18 dB oder mehr gegenüber einem Wert ohne resonanzbildendes Element verursacht. Beispielsweise wäre es denkbar, dass eine Kapazität parallel zu der Leiterschleife angeordnet ist und mit dieser einen Parallelschwingkreis bei der Resonanzfrequenz ausbildet. In einer bevorzugten Ausführungsform ist jeweils mit der ersten Leiterschleife und der zweiten Leiterschleife je ein resonanzbildendes Element koppelt.

Auf vorteilhafte Weise erhöht ein resonanzbildendes Element die Effektivität der induktiven Übertragung durch die Leiterschleife bei der Resonanzfrequenz und verhindert gleichzeitig mit einer gedämpften Übertragung bei anderen Frequenzen das Ausbilden von Mantelwellen mit gefährlicher Amplitude bei diesen Frequenzen.

In einer möglichen Ausführungsform weist das resonanzbildende Element der erfindungsgemäßen Anschlussleitung eine erste Induktivität und eine erste Kapazität auf. Es ist beispielsweise denkbar, dass eine dritte Leiterschleife und eine Kapazität vorgesehen sind, die derart angeordnet sind, dass sie mit der ersten Leiterschleife und/oder zweiten Leiterschleife induktiv wechselwirken. Diese könnten beispielsweise auf der Leiterplatte konzentrisch zu der ersten und/oder zweiten Leiterschleife angeordnet sein.

Auf vorteilhafte Weise kann ein mit einer Induktivität und einer Kapazität ausgeführtes resonanzbildendes Element in eine induktive Verbindung eingekoppelt werden und so das Frequenzverhalten modifizieren. Die von der induktiven Verbindung unabhängige zusätzliche Induktivität macht dabei auf vorteilhafte Weise das Frequenzverhalten im Wesentlichen unabhängig von der ersten und der zweiten Leiterschleife.

In einer möglichen Ausführungsform der erfindungsgemäßen Anschlussleitung weist die Anschlussleitung ein mechanisches Steckelement mit einer ersten Leiterschleife auf. Das mechanische Steckelement ist ausgelegt, mit einem korrespondierenden Kopplungselement mit einer zweiten Leiterschleife eine mechanische Verbindung mit einem resonanten kontaktlosen Leistungskoppler bereitzustellen. Als Steckelement und Kopplungselement ist im Sinne der Erfindung jedes mechanische Stecker-Buchse System zu verstehen, das geeignet ist, eine lösbare Verbindung zwischen Steckelement und Kopplungselement herzustellen, die eine vorbestimmte Relativposition von Steckelement und Kopplungselement vorgibt und die erste Leiterschleife und die zweite Leiterschleife in magnetische Kopplung bringt. In der vorbestimmten Relativposition sind dabei die erste Leiterschleife und die zweite Leiterschleife durch einen Isolator oder Luftspalt galvanisch voneinander isoliert. Ein resonanzbildendes Element ist in dem Steckelement und/oder dem Kopplungselement vorgesehen, sodass Steckelement und Kopplungselement in der vorbestimmten Relativposition einen resonanten kontaktlosen Leistungskoppler bereitstellen.

Auf vorteilhafte Weise stellt die erfindungsgemäße Anschlussleitung mit dem Steckelement eine sichere und verschmutzungsunempfindliche Steckverbindung für eine Empfangsantenne bereit.

In einer denkbaren Ausführungsform der erfindungsgemäßen Anschlussleitung weist die Anschlussleitung ein verdrilltes Leiterpaar bzw. Adernpaar auf. Denkbar sind beispielsweise verdrillte Adernpaare von CAT-Leitungen aus der Netzwerktechnik.

Verdrillte Leiterpaare bzw. Adernpaare sind aufgrund der Symmetrie auf vorteilhafte Weise unempfindlich gegen Induktion von außen, da sich die induzierten Ströme jeweils aufheben.

In einer möglichen Ausführungsform der erfindungsgemäßen Empfangsantenne weist die Empfangsantenne einen Signalumsetzer auf. Der Signalumsetzer ist ausgelegt, ein empfangenes Magnetresonanzsignal in einen Frequenzbereich umzusetzen, der in einem Resonanzbereich des resonanten kontaktlosen Leistungskopplers liegt. Beispielsweise kann ein empfangenes und verstärktes Magnetresonanzsignal durch einen Mischer mit einer Oszillatorfrequenz auf die Resonanzfrequenz als Zwischenfrequenz umgesetzt werden. Es ist aber auch denkbar, dass das Magnetresonanzsignal in der Empfangsantenne digitalisiert und auf eine Trägerwelle mit der Resonanzfrequenz moduliert wird.

Dabei ist es denkbar, dass eine gemeinsame Anschlussleitung für die Energieversorgung und die Übertragung der empfangenen Magnetresonanzsignale vorgesehen ist. Es ist aber ebenso denkbar, dass mehrere erfindungsgemäße Anschlussleitungen zum Übertragen von unterschiedlichen Signalen vorgesehen sind.

Auf vorteilhafte Weise ermöglicht der Signalumsetzer, das Magnetresonanzfrequenzsignal für eine Übertragung über die erfindungsgemäße Anschlussleitung auf die Resonanzfrequenz des resonanten kontaktlosen Leistungskopplers umzusetzen.

In einer denkbaren Ausführungsform der erfindungsgemäßen Empfangsantenne weist die Empfangsantenne einen Demodulator auf, der ausgelegt ist, eine in dem Hochfrequenzsignal modulierte Information zu dekodieren.

Auf vorteilhafte Weise ist es so denkbar, einer Steuerung in der Empfangsantenne Befehle zu übermitteln, beispielsweise kann die Steuerung ausgelegt sein, die Empfangsantenne während Anregungspulsen des Magnetresonanztomographen zu verstimmen.

In einer möglichen Ausführungsform des erfindungsgemäßen Systems weist der Wechselstromgenerator des Magnetresonanztomographen einen Modulator auf. Der Modulator ist dabei ausgelegt, eine Information auf den Wechselstrom zu modulieren.

Auf vorteilhafte Weise ermöglicht der Modulator, ohne zusätzliche Verbindungsleitungen Signale und Einstellungen an die Empfangsantenne zu senden.

In einer denkbaren Ausführungsform des erfindungsgemäßen Systems mit einer Empfangsantenne mit Signalumsetzer weist der Magnetresonanztomograph eine Empfangseinrichtung auf, die ausgelegt ist, ein durch den Signalumsetzer der Empfangsantenne in einen Resonanzbereich des resonanten kontaktlosen Leistungskopplers umgesetztes Magnetresonanzsignal zu empfangen und auszuwerten.

Auf vorteilhafte Weise kann die Anschlussleitung über ein gemeinsames Adernpaar Energie und geg. Falls Steuerkommandos zu der Empfangsantenne übertragen und in Gegenrichtung empfangene Magnetresonanzsignale, die dann durch den Magnetresonanztomographen empfangen, ausgewertet und als Bilder wiedergegeben werden können.

In einer möglichen Ausführungsform des erfindungsgemäßen Systems weist das System eine Patientenliege auf, wobei in der Patientenliege eine erste Anschlussleitung nach einem der Ansprüche 1 bis 9 angeordnet ist.

Die erfindungsgemäße Anschlussleitung kann als flache flexible Leiterplatte ausgeführt werden und benötigt daher nur eine geringe Bauhöhe in der Patientenliege. Die Patientenliege selbst kann deshalb besonders dünn konstruiert sein, was insbesondere unter den beengten Platzverhältnissen der Patientendurchführung ein großer Vorteil ist.

In einer denkbaren Ausführungsform des erfindungsgemäßen Systems weist die Patientenliege eine zweite Anschlussleitung für den Anschluss an eine Lokalspule auf. Vorzugsweise ist die Anschlussleitung oder zumindest der resonante kontaktlose Leistungskoppler dabei mit einer flexiblen Leiterplatte aufgebaut, sodass er in begrenztem Umfang flexibel ist. Die Patientenliege weist dabei eine Rückholvorrichtung auf, die ausgelegt ist, die zweite Anschlussleitung ausziehbar in der Patientenliege anzuordnen. Beispielsweise kann die Rückholvorrichtung einen Wickelkern aufweisen, an dem die zweite Anschlussleitung befestigt ist und durch eine Federspannung bei Auslösen einer Raste oder Bremse selbsttätig aufwickelbar ist. Denkbar ist z.B. aber auch eine Spannvorrichtung, die durch Federzug die zweite Anschlussleitung in einer oder mehreren parallelen, auch über Umkehrrollen gegenläufigen Bahnen einzieht, wenn eine Arretierung gelöst wird.

Die flexible und flache erfindungsgemäße Anschlussleitung erlaubt es auf vorteilhafte Weise, die Anschlussleitung platzsparend aufzurollen oder über kleine Radien umzulenken, sodass eine Anschlussleitung für eine Lokalspule auch permanent an der Patientenliege vorgesehen sein kann, was die Handhabung wesentlich vereinfacht.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines erfindungsgemäßen Systems aus Magnetresonanztomograph, Empfangsantenne und Anschlussleitung.
- Fig. 2: eine schematische Darstellung eines Abschnittes einer erfindungsgemäßen Anschlussleitung;
- Fig. 3: eine schematische Darstellung einer erfindungsgemäßen Anschlussleitung mit mehreren resonanten kontaktlosen Leitungskopplern;
- Fig. 4: eine schematische Darstellung einer erfindungsgemäßen Empfangsantenne;
- Fig. 5: eine schematische Darstellung einer Steuereinheit eines erfindungsgemäßen Magnetresonanztomographen:
- Fig. 6: eine schematische Darstellung eines Stecker/Buchse-Systems einer erfindungsgemäßen Anschlussleitung.

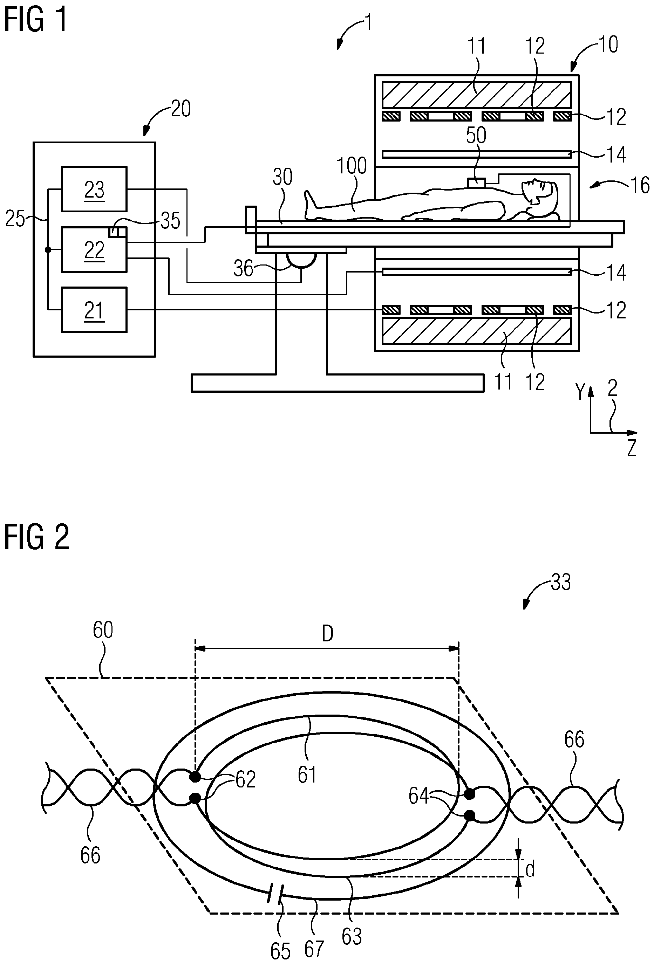

Fig. 1 zeigt eine schematische Darstellung einer Ausführungsform eines erfindungsgemäßen Systems aus Magnetresonanztomograph, Empfangsantenne und Anschlussleitung.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich ist in einem Patiententunnel 16 angeordnet, der sich in einer Längsrichtung 2 durch die Magneteinheit 10 erstreckt. Eine Patientenliege 30 ist von der Verfahreinheit 36 in dem Patiententunnel 16 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Auf dem Patienten 100 ist eine Lokalspule 50 angeordnet, die über eine erfindungsgemäße Anschlussleitung 33 mit der Hochfrequenzeinheit 22 verbunden ist. Die Hochfrequenzeinheit 22 weist vorzugsweise einen Wechselstromgenerator 35 auf, der eine hochfrequente Wechselspannung bzw. Wechselstrom zur Energieversorgung der Lokalspule 50 bereitstellt, die über die Anschlussleitung 33 übertragen wird. In umgekehrter Richtung ist die Lokalspule 50 ausgelegt, empfangene Magnetresonanzsignale in einen Frequenzbereich umzusetzen, der über die erfindungsgemäße Anschlussleitung 33 übertragen werden kann. Details zu den einzelnen Komponenten sind nachfolgend zu den anderen Figuren beschrieben.

In Fig. 2 ist ein Abschnitt einer erfindungsgemäßen Anschlussleitung 33 mit einem resonanten kontaktlosen Leistungskoppler 60 dargestellt. Der resonante kontaktlose Leistungskoppler 60 weist eine erste Leiterschleife 61 auf, die die beiden ersten Pole 62 elektrisch miteinander verbindet und dabei eine Fläche umschließt. Dabei ist der Durchmesser D der Schleife vorzugsweise kleiner als 30 mm. Dabei hängt der Durchmesser unter anderem von der Resonanzfrequenz, bei der eine Energieübertragung erfolgen soll und einer gewünschten Effizienz des resonanten kontaktlose Leistungskoppler 60 ab. Mit größerem Durchmesser kann die Effizienz erhöht werden, wobei bei höherer Frequenz ein kleinerer Durchmesser ausreicht. Es ist dabei auch denkbar, dass die erste Leiterschleife mehrere Windungen aufweist.

An die ersten Pole 62 ist ein erster Abschnitt von elektrischen Leitern 66 bzw. Adern der Anschlussleitung 33 angeschlossen, sodass die Leiterschleife 61 diese elektrisch miteinander verbindet. Die ersten Pole 62 und die erste Leiterschleife 61 können beispielsweise als Leiterbahn auf einem Substrat einer Leiterplatte ausgeführt sein, die aber in Fig. 2 der Übersichtlichkeit halber nicht dargestellt ist. Als Substrat wird vorzugsweise ein Material verwendet, das bei der vorgesehenen Resonanzfrequenz geringe dielektrische Verluste aufweist, beispielsweise ein mit FR4 bezeichnetes Material für Frequenzen im MHz-Bereich.

Die zweite Leiterschleife 63 ist durch einen Abstand d getrennt parallel zu der ersten Leiterschleife 61 angeordnet.

Der Abstand und die parallele Anordnung kann beispielsweise dadurch erreicht werden, dass die erste Leiterschleife 61 und die zweite Leiterschleife 62 auf gegenüberliegenden, flächigen Seiten eines Substrats einer Leiterplatte angeordnet sind, sodass sich der Abstand d durch die Dicke des Substrats ergibt. In dieser Ausführungsform dient das Substrat der Leiterplatte als Isolator.

Es ist dabei auch denkbar, dass die Leiterplatte nicht eben ist, sondern beispielsweise ein flexibles Substrat aufweist, das gekrümmt sein kann. Selbst ein mit dem Ort wechselnder Abstand der ersten Leiterschleife 61 zu der zweiten Leiterschleife 63 ist möglich, solange dieser zeitlich konstant ist, sodass die elektrische und/oder magnetische Kopplung der beiden Leiterschleifen in ausreichender Stärke aufrecht erhalten bleibt und sich die Resonanzfrequenz des resonanten kontaktlosen Kopplers nicht wesentlich ändert, d.h. um weniger als 1%, 5% oder 10%. Vorzugsweise ist der Abstand kleiner als 7 mm, beispielsweise weniger als 5 mm, 2 mm oder 1 mm.

Die Resonanz bei einer vorbestimmten, für die Energieübertragung günstigen Frequenz, wird durch ein oder mehrere resonanzbildende Elemente erzielt. In einer bevorzugten Ausführungsform des resonanten kontaktlosen Leistungskopplers 60 handelt es sich bei dem resonanzbildenden Element um eine oder mehrere dritte Leiterschleifen 67, beispielsweise um je eine dritte Leiterschleife 67, die jeweils um die erste Leiterschleife 61 oder die zweite Leiterschleife 63 herum angeordnet ist, beispielsweise jeweils auf einer Oberfläche der Leiterplatte. Wegen der Übersicht ist in Fig. 2 davon nur die dritte Leiterschleife 67 um die erste Leiterschleife 61 dargestellt.

Die dritte Leiterschleife 67 stellt eine Induktivität dar, die auch eine Eigenkapazität aufweist und somit bei einer Eigenfrequenz eine Resonanz hervorruft. Da diese Frequenz üblicherweise deutlich höher ist als technisch sinnvolle Frequenzen für die Energieübertragung im MHz- und GHz-Bereich, wird vorzugsweise die Resonanzfrequenz durch eine zusätzliche Kapazität, je nach Frequenzbereich durch einen Kondensator 65 oder durch eine beispielsweise auf der Leiterplatte ausgebildete Kapazität auf einen für die vorbestimmte Resonanzfrequenz geeigneten Wert gebracht. Um die Resonanzfrequenz zu senken, ist es auch denkbar, die Induktivität durch mehrere Windungen der Leiterschleife zu einer Spule zu erhöhen.

Vorzugsweise weist jeweils die erste Leiterschleife 61 und die zweite Leiterschleife 63 jeweils eine eigene dritte Leiterschleife 67 auf, um beide voneinander unabhängig abstimmen zu können. Es wäre aber auch grundsätzlich denkbar, die erste Leiterschleife 61 und die zweite Leiterschleife 63 durch gemeinsame Ankopplung an eine einzige dritte Leiterschleife 67 resonant zu machen.

Weiterhin ist es auch denkbar die erste Leiterschleife 61 und die zweite Leiterschleife 63 selbst resonant auf der gewünschten Resonanzfrequenz auszugestalten, beispielsweise durch eine Kapazität, die die ersten Pole 62 und zweiten Pole 63 verbindet und aus der ersten Leiterschleife 61 und der zweiten Leiterschleife 63 Parallelresonanzkreise macht. Die Resonanzfrequenz ist dabei durch die Geometrie der Leiterschleifen und die Kapazitäten bestimmt.

Die elektrischen Leiter 66 der Anschlussleitung 33, die an die ersten Pole 62 und die zweiten Pole 64 angeschlossen sind, können vorzugsweise wie dargestellt als verdrillte Zweidrahtleitung (twisted pair) ausgeführt werden, es ist aber beispielsweise auch eine Ausführung als geschirmte Koaxialleitung denkbar. Twisted-Pair Kabel sind kostengünstig als LAN-Kabel verfügbar und sind wegen der Verdrillung wenig anfällig auf induzierte Ströme.

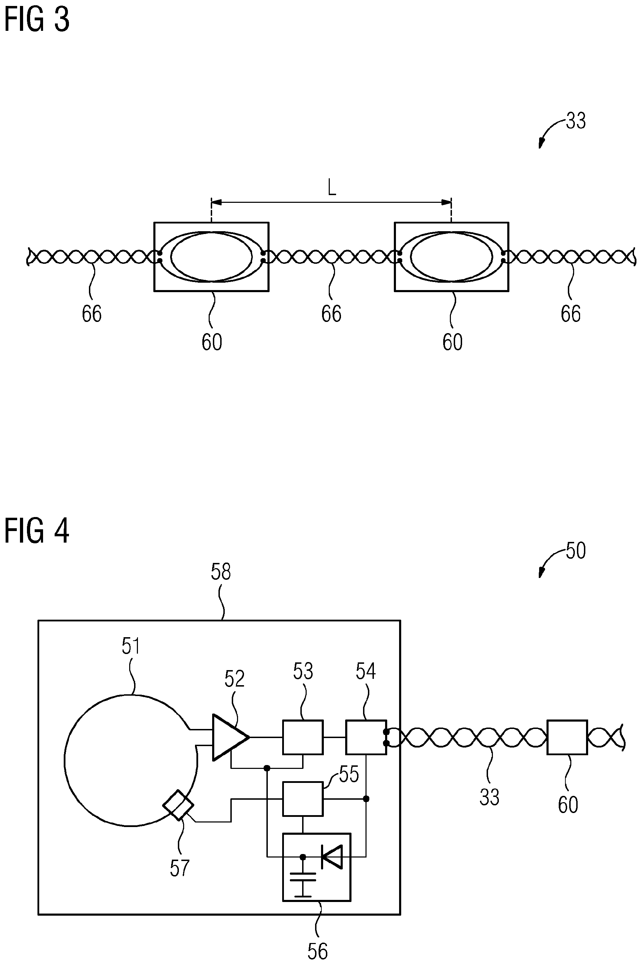

In Fig. 3 ist ein Abschnitt einer erfindungsgemäßen Anschlussleitung 33 mit mehreren resonanten kontaktlosen Leistungskopplern 60 dargestellt. Die resonanten kontaktlosen Leistungskoppler 60 weisen dabei einen Abstand L auf, der kleiner als ein Viertel der Wellenlänge der Larmorfrequenz des Magnetresonanztomographen 1 auf den elektrischen Leitern 66 ist. Ist ein Magnetresonanztomograph 1 für unterschiedliche Kerne ausgelegt, so handelt es sich dabei um die Wellenlänge der höchsten auftretenden Larmorfrequenz.

In Fig. 4 ist eine mögliche Ausführungsform einer erfindungsgemäßen Empfangsantenne, hier beispielsweise als Lokalspule 50 dargestellt. Die Lokalspule 50 weist eine Antennenspule 51 auf, mit der Magnetresonanzsignale empfangen werden und anschließend durch den rauscharmen Vorverstärker 52 als aktivem Verstärkerelement verstärkt werden. In einem weiteren Schritt werden die Magnetresonanzsignale durch einen Signalumsetzer 53 in einen Frequenzbereich umgesetzt, der durch den resonanten kontaktlosen Leistungskoppler 60 übertragen werden kann. Der Signalumsetzer 53 kann beispielsweise ein analoger oder digitaler Frequenzmischer sein. Es ist auch denkbar, dass das Magnetresonanzsignal in dem Signalumsetzer durch einen AD-Wandler digitalisiert und auf eine Trägerfrequenz im Übertragungsbereich des resonanten kontaktlosen Leistungskopplers 60 moduliert wird.

Ein Diplexer 54 trennt die über die Anschlussleitung 33 ein- und ausgehenden Signale. Der Diplexer 54 kann beispielsweise anhand der Frequenzen trennen, wenn der Übertragungsbereich des resonanten kontaktlosen Leistungskoppler 60 breit genug ist, um zwei unterschiedliche Trägerfrequenzen zu übertragen, die anschließend durch Filter mit vertretbarem Aufwand auch wieder ausreichend trennbar sind. Dabei ist es denkbar, dass zur Energieübertragung eine Frequenz mit genau der Resonanzfrequenz des resonanten kontaktlosen Leistungskopplers 60 übereinstimmt, um eine möglichst hohe Effizienz der Energieübertragung zu gewährleisten. Informationsübertragungen hingegen können an den Rändern des Resonanzbereichs stattfinden, da hier eine größere Dämpfung durch eine Verstärkung ausgeglichen werden können, insbesondere bei gesicherter digitaler Übertragung.

Der Diplexer 54 kann aber auch beispielsweise durch die Ausbreitungsrichtung der Welle auf der Anschlussleitung die Signale trennen. Denkbar sind hierzu z.B. Gyratoren oder Richtkoppler.

Zum Empfang von Steuerkommandos kann in der erfindungsgemäßen Empfangsantenne bzw. Lokalspule 50 ein Demodulator 55 vorgesehen sein, der über die Anschlussleitung empfangene Information demoduliert und an die Untereinheiten ausgibt. Vorzugsweise weist der Demodulator 55 auch eine Steuerung zur Interpretation der Information auf. Die Information kann im einfachsten Fall mittels Amplitudenmodulation, Frequenzmodulation oder anderer analoger oder digitaler Modulation auf die Frequenz moduliert sein, mit der Energie zu der Empfangsspule übertragen wird. Beispielsweise kann ein Pilotton übertragen werden, mit dem ein Detuningeinheit 57 aktiviert und ein Verstimmen der Antennenspule 51 ausgeführt oder die Antennenspule 51 unterbrochen werden kann.

Es ist auch denkbar, dass die Information ein Referenztakt ist, der genutzt wird, um bei einem analogen Signalumsetzer ein phasengenaues Mischsignal zu übertragen oder bei einem digitalen Signalumsetzer einen hochgenauen Referenztakt für die Digitalisierung. So kann systemweit die Phase des MR-Signals genau gemessen werden.

Die Energieversorgung 56 richtet das Signal zur Energieübertragung gleich und glättet bzw. puffert es durch eine Kapazität. Die so empfangene Energie wird an die anderen Einheiten wie rauscharmer Vorverstärker, Signalumsetzer und Demodulator weiter verteilt.

Die einzelnen Elemente der Empfangsspule bzw. Lokalspule 50 sind in einem Gehäuse 58 angeordnet, das vorzugsweise abgeschirmt ist.

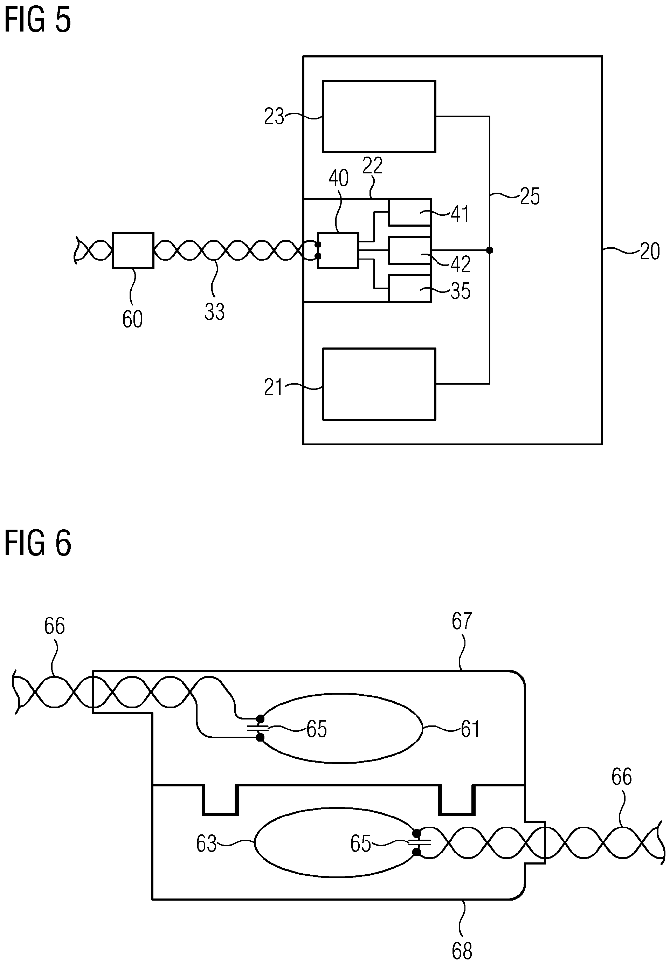

Fig. 5 zeigt eine mögliche Ausführungsform einer Steuereinheit 20 eines Magnetresonanztomographen 1 eines erfindungsgemäßen Systems. Der Magnetresonanztomograph 1 in Fig. 5 weist die zu der Lokalspule 50 in Fig. 4 korrespondierenden Einheiten auf.

Die Hochfrequenzeinheit 22 weist zum Einen einen Diplexer 40 auf, der ausgelegt ist, die unterschiedlichen über den resonanten kontaktlosen Leistungskoppler 60 bzw. die Anschlussleitung 33 zu übertragenden Signale zu kombinieren bzw. eingehende Signale zu trennen. Hierbei gilt das bereits zu dem Diplexer 54 der Lokalspule 50 Gesagte, eine Kombination kann beispielsweise anhand unterschiedlicher Frequenzen und/oder unterschiedlicher Ausbreitungsrichtung der Signale erfolgen.

Eine Empfangseinrichtung 41 erhält von dem Diplexer 40 eingehende Magnetresonanzsignale und wertet diese für eine nachfolgende Bildverarbeitung aus, beispielweise indem die Signale digitalisiert werden, um Amplitude, Frequenz und Phase auswerten zu können. Ein Wechselstromgenerator 35 erzeugt ein Hochfrequenzsignal mit einer Frequenz gleich oder nahe der Resonanzfrequenz des resonanten kontaktlosen Leistungskopplers 60 und führt dieses dem Diplexer 40 zu, der es über die Anschlussleitung 33 zu der Lokalspule 50 übertragt. Dabei ist es in einer bevorzugten Ausführungsform möglich, dass ein Modulator 42 Informationen auf das Signal des Wechselstromgenerators 35 aufprägt. So kann durch eine Amplitudenmodulation, eine Frequenzmodulation oder ein anderes analoges oder digitales Modulationsverfahren ein Referenztakt zu der Lokalspule übertragen werden oder auch Einstellkommandos, beispielsweise um durch einen Pilotton oder eine digitale Kommandosequenz das Detuning 57 der Antennenspule 51 zu aktivieren.

Fig. 6 zeigt eine schematische Darstellung eines Stecker/Buchse-Systems einer erfindungsgemäßen Anschlussleitung 33. Dabei ist der resonante kontaktlose Leistungskoppler 60 mit den gleichen Elementen aufgebaut, die zu Fig. 2 bereits erläutert wurden. Jedoch befindet sich die erste Leiterschleife 61 in einem mechanischen Steckelement 69.

Das mechanische Steckelement 69 ist dabei ausgelegt, mit einem korrespondierenden Kopplungselement 68 in eine lösbare mechanische Verbindung gebracht zu werden. Dabei können an mechanischem Steckelement 69 und dem Kopplungselement 68 wechselwirkende Haltevorrichtungen wie Haken, Rasten, Führungselemente und Ausnehmungen vorgesehen sein, um eine vorbestimmte Relativposition der von Steckelement 69 und Kopplungselement 68 zu sichern. In dieser gesicherten Relativposition sind die erste Leiterschleife 61 und die zweite Leiterschleife 63 so angeordnet, dass sie durch einen Luftspalt oder beispielsweise das Material des Steckelements 69 und/oder des Kopplungselements 68 als Isolator von einender getrennt sind, sich aber gleichzeitig mit von der ersten Leiterschleife 61 und der zweiten Leiterschleife 63 umschlossenen Flächen so gegenüber stehen, dass eine starke magnetische Wechselwirkung besteht. Vorzugsweise sind die erste Leiterschleife 61 und die zweite Leiterschleife 63 so angeordnet, dass die umschlossenen Flächen sich parallel zu einander und mit möglichst geringem Abstand deckungsgleich zueinander gegenüberstehen.

Denkbar ist es auch, in einem Steckelement 69 jeweils mehrere erste Leiterschleifen 61 und einem Kopplungselement 68 mehrere zweite Leiterschleifen 63 nebeneinander anzuordnen, sodass diese jeweils miteinander paarweise magnetisch gekoppelt sind und auf diese Weise in der Anschlussleitung 33 voneinander unabhängige Übertragungskanäle bereitzustellen. Es ist lediglich in Richtung parallel zu einer Ebene der Leiterschleifen 61, 63 für einen ausreichenden Abstand zu sorgen sodass zwischen den einzelnen Leiterschleifen 61, 63 der unterschiedlichen Übertragungskanäle das Übersprechen klein genug ist. Es genügt dazu, den Abstand in einer Größenordnung der Abmessung der Leiterschleifen 61, 63 und insbesondere groß in Bezug auf den Abstand der ersten Leiterschleife 61 und der zweiten Leiterschleife 63 eines korrespondierenden Paares zu halten.

Das Kopplungselement 68 kann dabei auch in einem Gehäuse einer Patientenliege angeordnet oder als Teil des Gehäuses ausgeführt sein. Die Anschlussleitung 33 stellt dabei einen zuverlässigen und vor Verunreinigungen sicheren Anschluss bereit

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Anschlussleitung für eine Empfangsantenne eines Magnetresonanztomographen (1), wobei die Empfangsantenne aktive Verstärkerelemente aufweist, wobei die Anschlussleitung (33) einen resonanten kontaktlosen Leistungskoppler (60) aufweist.

2. Anschlussleitung nach Anspruch 1, wobei eine Resonanzfrequenz des resonanten kontaktlosen Leistungskopplers (60) ungleich einer Larmorfrequenz des Magnetresonanztomographen (1) ist.

3. Anschlussleitung nach Anspruch 1 oder 2, wobei die Anschlussleitung (33) zwei oder mehr resonante Leistungskoppler (60) aufweist.

4. Anschlussleitung nach einem der vorhergehenden Ansprüche, wobei der resonante kontaktlose Leistungskoppler (60) einen ersten Anschluss und einen zweiten Anschluss mit jeweils zwei Polen (52, 63) und einen Isolator aufweisen, wobei der erste Anschluss und der zweite Anschluss durch den Isolator galvanisch voneinander isoliert sind.

5. Anschlussleitung nach Anspruch 4, wobei die ersten Pole (62) des ersten Anschlusses durch eine erste Leiterschleife (61) miteinander verbunden und die Pole (64) des zweiten Anschlusses durch eine zweite Leiterschleife (63) miteinander verbunden sind, wobei die erste Leiterschleife (61) durch den Isolator von der zweiten Leiterschleife (63) getrennt ist, wobei eine Projektion einer von der ersten Leiterschleife (61) umschlossen ersten Fläche auf eine von der zweiten Leiterschleife (63) umschlossenen zweite Fläche die zweite Fläche im Wesentlichen umfasst.

6. Anschlussleitung nach Anspruch 5, wobei die erste Leiterschleife (61) mit einem resonanzbildenden Element elektrisch und/oder magnetisch gekoppelt ist.

7. Anschlussleitung nach Anspruch 6, wobei das resonanzbildende Element eine erste Induktivität und eine erste Kapazität aufweist.

8. Anschlussleitung nach einem der Ansprüche 4 bis 6, wobei die Anschlussleitung (33) ein mechanisches Steckelement (69) mit einer ersten Leiterschleife (61) aufweist, wobei das mechanische Steckelement (69) ausgelegt ist, mit einem korrespondierenden Kopplungselement (68) mit einer zweiten Leiterschleife (63) eine mechanische Verbindung einen resonanten kontaktlosen Leistungskoppler (60) bereitzustellen.

9. Anschlussleitung nach einem der vorhergehenden Ansprüche, wobei die Anschlussleitung (33) ein verdrilltes Adernpaar aufweist.

10. Empfangsantenne mit einer Anschlussleitung (33) nach einem der vorhergehenden Ansprüche, wobei die Empfangsantenne ein aktives Verstärkerelement und eine Energieversorgung (56) aufweist, wobei die Energieversorgung (56) ausgelegt ist aus einem über die Anschlussleitung (33) übertragenen Hochfrequenzsignal mit der Resonanzfrequenz des resonanten kontaktlosen Leistungskopplers (60) das aktive Verstärkerelement mit Energie zu versorgen

11. Empfangsantenne nach Anspruch 10, wobei die Empfangsantenne einen Signalumsetzer (53) aufweist, der ausgelegt ist, ein empfangenes Magnetresonanzsignal in einen Frequenzbereich umzusetzen, der in einem Resonanzbereich des resonanten kontaktlosen Leistungskopplers (60) liegt.

12. Empfangsantenne nach Anspruch 10 oder 11, wobei die Empfangsantenne einen Demodulator (55) aufweist, der ausgelegt ist, eine in dem Hochfrequenzsignal modulierte Information zu dekodieren.

13. System aus einem Magnetresonanztomographen (1) und einer Empfangsantenne nach einem der Ansprüche 10 bis 12, wobei die Empfangsantenne mittels der Anschlussleitung (33) magnetisch resonant mit dem Magnetresonanztomographen (1) gekoppelt ist, wobei der Magnetresonanztomograph (1) einen Wechselstromgenerator (35) aufweist, der mit der Anschlussleitung (33) verbindbar ist und ausgelegt ist, das aktive Verstärkerelement der Empfangsantenne mit Energie zu versorgen und einen Wechselstrom mit einer Frequenz zu erzeugen, die im Wesentlichen gleich einer Resonanzfrequenz des resonanten kontaktlosen Leistungskopplers (60) ist.

14. System nach Anspruch 13 und einer Empfangsantenne nach Anspruch 12, wobei der Wechselstromgenerator (35) einen Modulator (42) aufweist, der ausgelegt ist, eine Information auf den Wechselstrom zu modulieren.

15. System nach Anspruch 13 mit einer Empfangsantenne nach Anspruch 11 oder 12, wobei der Magnetresonanztomograph (1) eine Empfangseinrichtung (41) aufweist, die ausgelegt ist, ein durch den Signalumsetzer (53) der Empfangsantenne in einen Resonanzbereich des resonanten kontaktlosen Leistungskopplers (60) umgesetztes Magnetresonanzsignal zu empfangen und auszuwerten.

16. System nach einem der Ansprüche 13 bis 15, wobei das System eine Patientenliege (30) aufweist und in der Patientenliege (30) eine erste Anschlussleitung nach einem der Ansprüche 1 bis 8 angeordnet ist.

17. System nach Anspruch 16, wobei die Patientenliege (30) eine zweite Anschlussleitung nach einem der Ansprüche 1 bis 8 und eine Rückholvorrichtung aufweist, wobei die Rückholvorrichtung ausgelegt ist, die zweite Anschlussleitung ausziehbar in der Patientenliege (30) anzuordnen.
